Europäisches Patentamt

European Patent Office

Office européen des brevets

(19)

(11)    **EP 1 423 935 B1**

(12)            **EUROPÄISCHE PATENTSCHRIFT**

(45) Veröffentlichungstag und Bekanntmachung des Hinweises auf die Patenterteilung:
**02.11.2006   Patentblatt 2006/44**

(21) Anmeldenummer: **02760159.0**

(22) Anmeldetag: **03.09.2002**

(51) Int Cl.:
***H04L 1/08*** (2006.01)

(86) Internationale Anmeldenummer:
**PCT/DE2002/003246**

(87) Internationale Veröffentlichungsnummer:
**WO 2003/024014 (20.03.2003 Gazette 2003/12)**

(54) **VERFAHREN ZUR ANPASSUNG DER BITRATE EINES IN EINEM KOMMUNIKATIONSSYSTEM ZU ÜBERTRAGENDEN BITSTROMS UND ENTSPRECHENDE KOMMUNIKATIONSVORRICHTUNG**

METHOD FOR ADAPTING THE BIT RATE OF A BIT STREAM WHICH IS TO BE TRANSMITTED IN A COMMUNICATION SYSTEM AND CORRESPONDING COMMUNICATION DEVICE

PROCEDE D'ADAPTATION DU DEBIT BINAIRE D'UN FLUX BINAIRE DEVANT ETRE TRANSMIS DANS UN SYSTEME DE COMMUNICATION ET DISPOSITIF DE COMMUNICATION CORRESPONDANT

(84) Benannte Vertragsstaaten:
**DE FR GB**

(30) Priorität: **05.09.2001   DE 10143497**

(43) Veröffentlichungstag der Anmeldung:
**02.06.2004   Patentblatt 2004/23**

(73) Patentinhaber: **SIEMENS AKTIENGESELLSCHAFT 80333 München (DE)**

(72) Erfinder:
• **DÖTTLING, Martin, Walter 85579 Neubiberg (DE)**

• **RAAF, Bernhard 81475 München (DE)**

(56) Entgegenhaltungen:
**WO-A-00/65726           WO-A-01/39420
WO-A-01/39422**

• **PANASONIC: "Enhanced HARQ Method with Signal Constellation Rearrangement" TSG-RAN WORKING GROUP 1 MEETING, XX, XX, Nr. 19, 27. Februar 2001 (2001-02-27) - 2. März 2001 (2001-03-02), XP002229383 Las Vegas, USA**

**EP 1 423 935 B1**

**EP 1 423 935 B1**

**Beschreibung**

Verfahren zur Anpassung der Bitrate eines in einem Kommunikationssystem zu übertragenden Bitstroms und entsprechende Kommunikationsvorrichtung

Die vorliegende Erfindung betrifft ein Verfahren zur Anpassung der Bitrate eines in einem Kommunikationssystem, insbesondere einem Mobilfunksytem, zu übertragenden Bitstroms sowie eine entsprechende Kommunikationsvorrichtung.

Die Mobilfunktechnik befindet sich in einer raschen Entwicklung. Augenblicklich wird an der Standardisierung der sogenannten UMTS-Mobilfunkstandards ("Universal Mobile Telecommunication System") für Mobilfunkgeräte der dritten Mobilfunkgeneration gearbeitet.

Dabei ist auf der Senderseite eine Ratenanpassung ("Rate Matching") vorgesehen, um die Bitrate des zu übertragenden Bitstroms an die jeweils mögliche Übertragungsrate anzupassen, wobei entweder Bits aus dem Bitstrom entfernt oder in dem Bitstrom vervielfacht, insbesondere verdoppelt, werden. Das Entfernen von Bits wird als Punktieren ("Puncturing") und das Vervielfachen als Repetieren ("Repetition") bezeichnet.

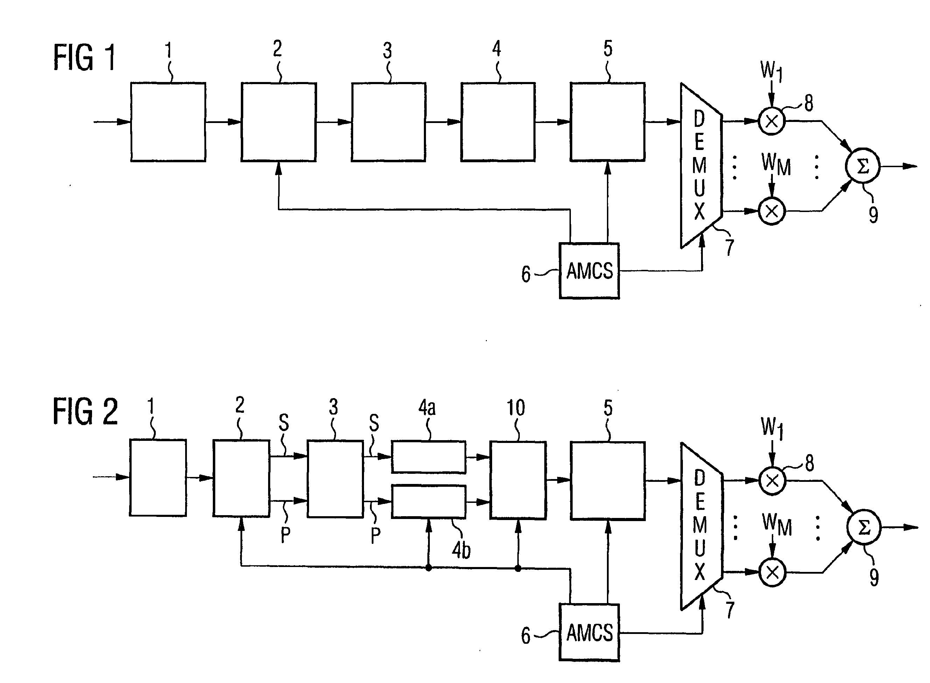

Ein möglicher Aufbau des Sendepfads eines Mobilfunksenders, bei dem eine derartige Bitratenanpassung vorgesehen ist, ist beispielhaft in Figur 1 dargestellt.

Ein aus mehreren Daten- oder Transportblöcken bestehender Datenstrom wird zunächst von einer Einrichtung 1 um sogenannte "Tail Bits" erweitert. Der von der Einrichtung 1 somit ausgegebene Bitstrom wird einem Kanalcodierer 2 zugeführt, wo den Informationsbits in Abhängigkeit von der jeweils angewendeten Art der Kanalcodierung redundante Bits hinzugefügt werden, so dass bei den meisten Codierungsschemata einerseits sogenannte systematische Bits und andererseits Paritätbits ("Parity Bits") erzeugt werden. Abhängig von der Coderate des Kanalcodierers 2 entstehen mehr oder weniger systematische Bits bzw. Paritätbits. Die Paritätbits besitzen bei einigen Codierungsschemata eine geringere Priorität bzw. Wichtigkeit für die Decodierung der entsprechenden Nachricht als die systematischen Bits. Bei dem Kanalcodierer 2 kann es sich beispielsweise in UMTS-Mobilfunksystemen um einen sogenannten TurboCodierer handeln, welcher in der Regel aus miteinander verschachtelten Faltungscodierern aufgebaut ist.

Dem Kanalcodierer 2 ist eine Bitratenanpassungseinrichtung 3 nachgeschaltet, welche die ihr zugeführten Bits gemäß einem bestimmten Bitratenanpassungsalgorithmus punktiert und/oder repetiert. Aufgrund der geringeren Wichtigkeit bzw. Priorität der Paritätbits werden herkömmlicherweise zur Bitratenanpassung bevorzugt die Paritätbits punktiert, da diese für eine erfolgreiche Decodierung der jeweiligen Nachricht auf der Empfängerseite weniger wichtig sind als die systematischen Bits.

Der von der Bitratenanpassungseinrichtung 3 ausgegebene Bitstrom wird mit Hilfe eines Interleavers 4 verwürfelt, so dass die einzelnen Bits gemäß einem bestimmten Interleavingschema zeitlich umgeordnet werden. Der Interleaver 4 hat zur Folge, dass bei dem von ihm ausgegebenen Bitstrom die Prioritäten der einzelnen Bits nicht mehr bekannt sind.

Die von dem Interleaver 4 ausgegebenen Bits werden einem Modulator 5 zugeführt, welcher abhängig von der jeweils angewendeten Modulationsart mehrere dieser Bits auf bestimmte Symbole eines mehrdimensionalen Symbolraums abbildet und die Symbole an einen Empfänger überträgt. Bei einer QPSK-Modulation ("Quadrature Phase Shift Keying") werden jeweils zwei Bits auf vier gleichmäßig in einem zweidimensionalen Symbolraum verteilte Symbole aufgeteilt, während bei einer 8PSK-Modulation drei Bits, bei einer 16QAM-Modulation ("Quadraturamplitudenmodulation") vier Bits und bei einer 64QAM-Modulation sechs Bits einem Symbol in einem zweidimensionalen Symbolraum zugewiesen werden.

Die von dem Modulator 5 erzeugten Symbole werden in Form eines Real- und Imaginärteils, welche eindeutig die Lage des jeweiligen Symbols in dem zweidimensionalen Symbolraum beschreiben, übertragen. Ein dem Modulator 5 nachgeschalteter Demultiplexer 7 verteilt die Symbole auf eventuell mehrere Kanäle, wo die Symbolfolge mit unterschiedlichen Kanalisierungs- bzw. Spreizcodes $W_1 ... W_M$ codiert werden, was in Figur 1 in Form entsprechender Multiplizierer 8 dargestellt ist. Über einen Summierer 9 wird das Summensignal dieser unterschiedlich kanalcodierten Symbolfolgen generiert und ausgegeben.

Darüber hinaus ist gemäß Figur 1 eine mit der Abkürzung AMCS ("Adaptive Modulation and Coding Schemes") versehene Steuereinheit 6 vorgesehen, welche das jeweils zu verwendende Modulationsalphabet des Modulators 5 sowie die Codierschemata und Coderaten des Kanalcodierers 2 und die Aufteilung auf die einzelnen Kanalisierungscodes durch den Demultiplexer 7 festlegt.

Die in Figur 1 gezeigte Sendepfadstruktur entspricht beispielsweise der für einen sogenannten HSDPA ("High Speed Downlink Packet Access") in UMTS-Mobilfunksytemen vorgesehenen Struktur der physikalischen Schicht. Dabei handelt es sich um eine paketvermittelte Verbindungsart, wobei zudem ein sogenanntes ARQ-Verfahren ("Automatic Repeat Request") zur Anwendung kommen kann, wobei der Empfänger (beispielsweise eine Mobilstation) eines Datenpakets bei einem fehlerhaften Empfang dieses Datenpakets eine erneute Übertragung desselben von dem Sender (beispielsweise einer Basisstation) anfordert, woraufhin der Sender eine Wiederholung des ursprünglich gesendeten Datenpakets an den Empfänger sendet.

Ein Problem bei der Funktion des in Figur 1 gezeigten Modulators 5 besteht darin, dass aufgrund der jeweils gewählten Modulationsart nicht alle dem Modulator 5 zugeführten Bits gleich sicher übertragen werden können, d.h. die Zuverlässigkeit der einzelnen Bits schwankt z.B. in Abhängigkeit von der Position des Symbols in dem Symbolraum, auf welche die einzelnen Bits abgebildet werden.

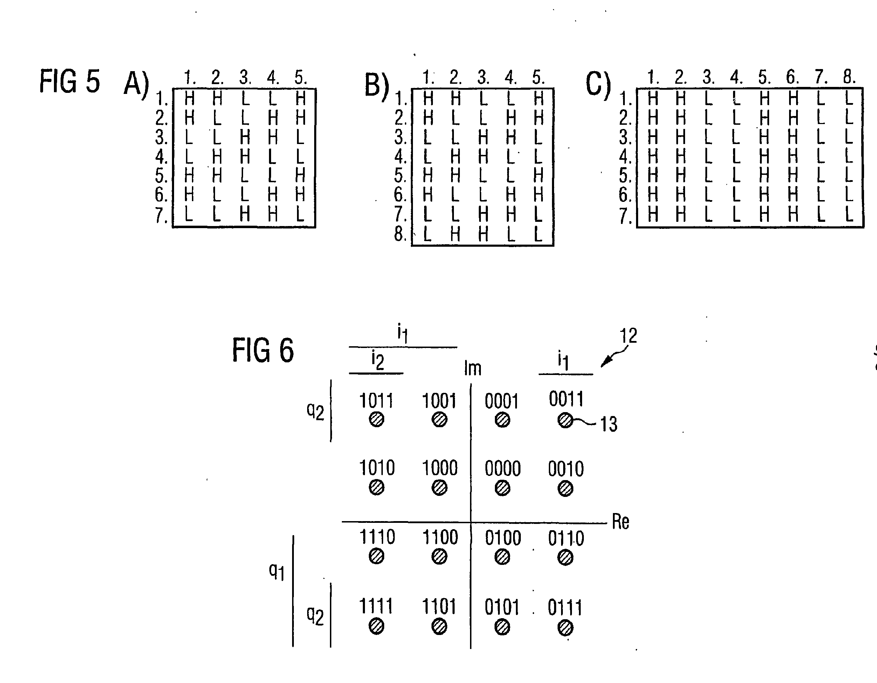

Dies soll nachfolgend näher unter Bezugnahme auf Figur 6 erläutert werden, wobei in Figur 6 beispielhaft die Signalkonstellation bzw. der zweidimensionale Symbolraum 12 für eine 16QAM-Modulation dargestellt ist. Dabei werden jeweils vier Bits $i_1$, $q_1$, $i_2$ und $q_2$ in der angegebenen Reihenfolge einem Symbol 13 des in Figur 6 gezeigten zweidimensionalen Symbolraums 12 zugeordnet, wobei die Art der Abbildung der einzelnen Bits auf die Symbole 13 als "Gray Mapping" bezeichnet wird. In Figur 6 sind jeweils diejenigen Spalten bzw. Zeilen von Symbolen mit einem Strich markiert, welche einem Bit $i_1$ oder $i_2$ bzw. $q_1$ oder $q_2$ mit dem Wert "1" entsprechen. Aus der Darstellung von Figur 6 ist ersichtlich, dass beispielsweise die Symbole mit $i_2$ = "1" jeweils acht Nachbarn mit dem Wert $i_2$ = "0" besitzen, während beispielsweise Symbole mit $i_1$ = "1" lediglich vier potentielle Nachbarn mit $i_1$ = "0" und somit auch nur vier direkte Entscheidungsschwellen besitzen. Dies hat zur Folge, dass die Symbole mit den Bits $i_1$ = "1" besser vor einer fehlerhaften Übertragung geschützt sind als die Symbole mit $i_2$ = "1". Das Gleiche gilt auch beispielsweise für die Symbole $q_1$ = "1", welche eine größere Zuverlässigkeit aufweisen als Symbole mit $q_2$ = "1". Grundsätzlich kann somit gesagt werden, dass bei der in Figur 6 gezeigten Signalkonstellation die Bits $i_1$ und $q_1$ eine größere Zuverlässigkeit hinsichtlich einer fehlerfreien Ermittlung des Informationsgehalts aufweisen als die Bits $i_2$ bzw. $q_2$.

Bei der in Figur 1 gezeigten Sendepfadstruktur tritt somit das Problem auf, dass einerseits Bits mit unterschiedlicher Priorität bzw. Wichtigkeit für die Decodierung der jeweiligen Nachricht vorgesehen sind und andererseits der Modulator 5 nicht sämtliche Bits gleich sicher übertragen bzw. auf gleich zuverlässige Symbole abbilden kann, welche dann in Form ihres Realteils Re bzw. ihrer Inphase-Komponente und ihres Imaginärteils Im bzw. ihrer Quadratur-Komponente übermittelt werden, so dass gegebenenfalls Bits mit hoher Priorität auf Symbole mit niedriger Zuverlässigkeit abgebildet und übertragen werden, worunter die Datenübertragungssicherheit und Datenübertragungsqualität leidet.

Diesbezüglich wurde bereits vorgeschlagen, für jeden Übertragungsversuch eines Datenblocks eine spezifische Zuordnung der Bits auf die Symbole 13 des Symbolraums 12 vorzunehmen, so dass bei Einsatz einer geschickten Zuordnungsvorschrift nach mehreren Übertragungen eine Angleichung der Zuverlässigkeit der einzelnen Bits erzielt werden kann. Dies trifft jedoch nur dann zu, wenn ein Datenblock mehrfach wiederholt wird. Die Übertragungssicherheit bei der ersten Übertragung eines Datenblocks wird durch diesen Vorschlag nicht verbessert. Zudem werden bei diesem Vorschlag nicht die unterschiedlichen Prioritäten der kanalcodierten Bits berücksichtigt. Ein weiteres mit diesem Vorschlag verbundenes Problem besteht darin, dass das Wiederholungsdatenpaket zwangsläufig nicht mit dem ursprünglich gesendeten Datenpaket aufgrund der unterschiedlichen Abbildung der einzelnen Bits auf die übertragenen Symbole identisch ist. Dies hat zur Folge, dass auf der Empfängerseite die beiden Wiederholungen nicht unmittelbar vor dem Demodulator kombiniert werden können, sondern stattdessen eine sogenannte Log-Likelihood-Kombination auf Bitebene durchgeführt werden muss. Dabei werden die empfangenen Inphase-und Quadratur-Werte zunächst in Wahrscheinlichkeiten für die übertragenen.Bits umgerechnet, um daraus die tatsächlich gesendeten Bits mit größtmöglicher Wahrscheinlichkeit abzuleiten. Die Log-Likelihood-Kombination weist jedoch gegenüber der zuvor erwähnten einfachen Symbolkombination, bei welcher die Symbole des ursprünglichen Datenpakets mit den Symbolen des Wiederholungsdatenpakets einfach vor dem Demodulator nach Anwendung einer Kanalschätzung gewichtet mit dem jeweiligen Signal/ Rausch-Verhältnis aufaddiert werden, insbesondere bei schlechten Übertragungseigenschaften eine schlechtere Performance auf. Darüber hinaus können mit der herkömmlichen Symbolkombination in einer (beispielsweise der Inphase-Komponente) zugeordneten Speicherstelle zwei Bitinformationen gehalten werden, so dass Speicherplatz gespart werden kann.

Ein weiterer Vorschlag ist in Figur 2 dargestellt, wobei nach dem Kanalcodierer bzw. Turbocodierer 2, welcher die Bits getrennt nach systematischen Bits S und Paritätbits P ausgibt, eine getrennte Verarbeitung der systematischen Bits und Paritätbits durchgeführt wird. Daher sind insbesondere zwei separate Interleaver 4a und 4b vorgesehen, wobei in einer Einrichtung 10 eine Parallel/Seriell-Umsetzung auf lediglich einen Bitstrom derart stattfindet, dass eine möglichst intelligente Zuordnung der Bits mit verschiedenen Prioriäten bzw. Wichtigkeiten auf die Bitpositionen mit unterschiedlicher Zuverlässigkeit innerhalb der einzelnen Symbole erfolgen kann. Dabei werden die Bits mit höchster Priorität, d.h. die systematischen Bits S; bevorzugt auf die Bitpositionen mit höchster Zuverlässigkeit und die Bits mit niedrigster Priorität, d.h. die Paritätbits, auf die Bitpositionen mit geringster Zuverlässigkeit verteilt. Da häufig mehr Bits mit höchster Priorität als Bitpositionen mit höchster Zuverlässigkeit vorhanden sind, ist in der Regel keine optimale Lösung möglich. Zudem erfordert diese Variante aufgrund der Mehrzahl an Interleavern und der zusätzlichen Einrichtung 10 einen erheblichen zusätzlichen Realisierungsaufwand.

Die Patentveröffentlichung WO0139422 A offenbart ein Verfahren zur Anpassung der Bitrate eines in einem Kommunikationssystem zu übertragenden Bitstroms wobei die Anpassung der Bitrate durch Punktieren oder Repetieren der Bits des Bitstroms erfolgt, wobei für jedes Bit ein aktualisierter Fehlerwert bestimmt und anhand dieses aktualisierten Fehlerwerts beurteilt wird, ob das entsprechende Bit punktiert bzw. repetiert werden soll oder nicht und wobei für jedes einkommende Bit ein Wert, der von der Wichtigkeit des jeweiligen Bits abhängt, vom Fehlerwert abgezogen wird; wobei jedesmal daß ein Bit repetiert ist, der Fehlerwert inkremetiert wird; und wobei ein Bit repetiert wird, bis der Fehlerwert größer wie Null ist.

Der vorliegenden Erfindung liegt die Aufgabe zugrunde, ein Verfahren zur Anpassung der Bitrate eines in einem Kommunikationssystem zu übertragenden Bitstroms sowie eine Kommunikationsvorrichtung bereitzustellen, wobei die Datenübertragungsqualität und Datenübertragungssicherheit mit möglichst geringem Aufwand verbessert werden kann. Insbesondere soll mit möglichst einfachen Mitteln eine möglichst gute Abbildung wichtiger Bits auf Bitpositionen mit hoher Zuverlässigkeit innerhalb der einzelnen Modulationssymbole gewährleistet sein.

Diese Aufgabe wird erfindungsgemäß durch ein Verfahren mit den Merkmalen des Anspruches 1 bzw. eine Kommunikationsvorrichtung mit den Merkmalen des Anspruches 17 gelöst. Die Unteransprüche definieren jeweils bevorzugte und vorteilhafte Ausführungsformen der vorliegenden Erfindung.

Erfindungsgemäß wird vorgeschlagen, zur Bitratenanpassung einen Bitratenanpassungsalgorithmus zu verwenden, in dem insbesondere bei der Punktierung bzw. Repetierung die Qualität bzw. Zuverlässigkeit der tatsächlich zur Übertragung dienenden Bits, mit welcher bei einer tatsächlichen Übertragung durch das jeweilige Bit ein bestimmter Informationsgehalt übermittelt werden kann, insbesondere die Zuverlässigkeit der entsprechenden Bitpositionen innerhalb der zu übertragenden Symbole, berücksichtigt wird.

Ideal ist eine Zuweisung der zu übertragenden Bits des jeweiligen Bitstroms zu den tatsächlich zur Übertragung zur Verfügung stehenden Bits derart, dass die Summe der Zuverlässigkeiten der für die Übertragung zur Verfügung stehenden Bits, welche einem bestimmten Bit des Bitstroms entsprechen, exakt proportional zur Wichtigkeit des jeweiligen Bits ist. Diese Zuordnung ist jedoch in der Praxis nur für Spezialfälle (z.B. wenn alle Bits dieselbe Wichtigkeit aufweisen und jedes Bit gleich häufig repetiert wird etc.) erreichbar.

Daher wird erfindungsgemäß vorgeschlagen, wenigstens im Mittel über mehrere aufeinanderfolgende Bits des zu übertragenden Bitstroms eine möglichst exakte Annäherung an dieses Ideal zu erreichen, d.h. die Punktierung/Repetierung derart zu gestalten, dass für eine bestimmte Anzahl aufeinanderfolgender Bits des zu übertragenden Bitstroms die Summe der Wichtigkeiten dieser Bits möglichst gut in einem festen Verhältnis zur Summe der Zuverlässigkeiten für diese Bits zur Übertragung verwendeten Bits steht.

Gemäß einem Ausführungsbeispiel der vorliegenden Erfindung ist diesbezüglich vorgesehen, lokal die Punktierungsrate zu erhöhen (bzw. die Repetierungsrate zu erniedrigen), wenn der Quotient aus der Summe der Wichtigkeiten der bisher zu übertragenden Bits geteilt durch die Summe der Zuverlässigkeiten der dafür zur Übertragung verwendeten Bits größer als ein vorgegebener Schwellenwert ist. Umgekehrt wird lokal die Punktierungsrate reduziert (bzw. die Repetierungsrate erhöht), wenn der Quotient aus der Summe der Wichtigkeiten der bisher zu übertragenden Bits geteilt durch die Summe der Zuverlässigkeiten der dafür zur Übertragung verwendeten Bits kleiner als der vorgegebene Schwellenwert ist.

Gemäß einem bevorzugten Ausführungsbeispiel der Erfindung wird dies dadurch erreicht, dass bei der Bestimmung eines Fehlerwerts, der ein Maß für die Abweichung zwischen der augenblicklichen Punktierungs- bzw. Repetierungsrate und der gewünschten Punktierungs- bzw. Repetierungsrate ist, ein Aktualisierungsparameter verwendet wird, welcher für jedes zur Übertragung dienende Bit bitspezifisch in Abhängigkeit von der Zuverlässigkeit, mit welcher bei einer tatsächlichen Übertragung durch das jeweilige Bit ein bestimmter Informationsgehalt übermittelt werden kann, gewählt wird. D.h. dieser Aktualisierungsparameter wird nicht konstant gewählt, sondern in Abhängigkeit von der Qualität bzw. Zuverlässigkeit der zu Übertragung dienenden Bits bitspezifisch verändert, so dass bei der Punktierung bzw. Repetierung die Qualität bzw. Zuverlässigkeit der zur Übertragung dienenden Bits berücksichtigt werden kann, was die Qualität und Sicherheit der Datenübertragung erhöht.

Besonders vorteilhaft ist es, wenn in dem Bitratenanpassungsalgorithmus nicht nur die Qualität und Zuverlässigkeit der zur Übertragung dienenden Bits berücksichtigt wird, sondern auch die Wichtigkeit bzw. Priorität der Bits des der Bitratenanpassung zu unterziehenden Bitstroms. Auch diesbezüglich kann ein entsprechender Aktualisierungsparameter verwendet werden, welcher individuell für jedes Bit des Bitstroms, für welches eine Entscheidung hinsichtlich Punktierung/Repetierung getroffen werden muss, bitspezifisch gewählt wird. Mit Hilfe der zuvor beschriebenen Maßnahmen kann somit sichergestellt werden, dass für eine gewisse Menge benachbarter Bits die Summe der Wichtigkeiten der zu übertragenden Bits stets so gut wie möglich in einem festen Verhältnis zur Summe der Zuverlässigkeiten der dafür zur Übertragung verwendeten Bits steht.

Erfindungsgemäß kommt insbesondere ein Bitratenanpassungalgorithmus zur Anwendung, welcher im Gegensatz zu herkömmlichen Bitratenanpassungsalgorithmen derart ausgestaltet ist, dass auf einfache Art und Weise in einem einzigen Datenblock sowohl Punktierung als auch Repetierung von Bits stattfinden kann, wobei die unterschiedlichen Wichtigkeiten und Zuverlässigkeiten von Bits innerhalb eines Datenblocks berücksichtigt werden können.

Um die zur Durchführung der vorliegenden Erfindung erforderlichen Informationen über die Zuverlässigkeit der einzelnen zur Übertragung dienenden Bits zu erhalten, können verschiedene Maßnahmen ergriffen werden. So können beispielsweise für unterschiedliche Bitklassen der unterschiedlichen Wichtigkeiten separate Interleaver verwendet werden, wobei die von den Interleavern ausgegebenen Bits der entsprechenden Bitklasse auf bestimmte Bitpositionen mit entsprechenden Zuverlässigkeiten der zu übertragenden Symbole abgebildet werden, so dass bei der Durchführung der Bitratenanpassung von vorneherein sowohl die Wichtigkeits- als auch Zuverlässigkeitsinformation vorhanden ist. Alternativ kann die Abfolge der Zuverlässigkeiten am Ausgang des Kanalcodierers auch aus den bekannten Zuverlässigkeiten in Abhängigkeit von der jeweils verwendeten Modulationsart durch Deinterleaving berechnet werden. Eine derartige explizite Deinterleavingoperation kann vermieden werden, falls der jeweils verwendete Interleaver zumindest in Bezug auf die Zuordnung der Bits verschiedener Bitklassen, welche jeweils unterschiedliche Zuverlässigkeiten aufweisen, eine einfache Zuordnungsregel implementiert, was in Abhängigkeit von der jeweils gewählten Modulationsart durch eine entsprechende Ausgestaltung des jeweiligen Interleavers erzielt werden kann. Hierfür werden nachfolgend bevorzugte Ausführungsbeispiele ausführlich erläutert.

Bei Untersuchungen zur Turbocodierung stellte sich heraus, dass die üblicherweise von einem Turbocodierer bereitgestellten Paritätbitströme nicht ganz gleichwertig sind, sondern dass es sinnvoll ist, die Paritätbits, welche im Turbodecodierer zuerst verwendet werden, mit einer etwas geringeren Punktierung zu senden als die Paritätbits des zweiten Paritätbitstroms. Somit könnten die Paritätbits des ersten Paritätbitstroms mit einer etwas höheren Wichtigkeit bzw. Priorität versehen werden als die Paritätbits des zweiten Paritätbitstroms.

In Kommunikationssystemen, bei welchen das bereits zuvor erläuterte ARQ-Verfahren Anwendung findet, kann die Wichtigkeit bzw. Priorität der einzelnen Bits auch in Abhängigkeit davon gewählt werden, zum wievielten Mal das entsprechende Datenpaket übertragen wird.

Die vorliegende Erfindung eignet sich bevorzugt zum Einsatz in Mobilfunksytemen, insbesondere zum Einsatz in UMTS-Mobilfunksystemen. Selbstverständlich ist jedoch die vorliegende Erfindung nicht auf diesen bevorzugten Anwendungsbereich beschränkt, sondern kann allgemein in jedem beliebigen Kommunikationssystem, wo senderseitig eine Bitratenanpassung durchgeführt wird, Anwendung finden. Darüber hinaus ist von der vorliegenden Erfindung nicht nur die Senderseite, sondern auch die Empfängerseite betroffen, da empfängerseitig ein erfindungsgemäß verarbeitetes Empfangssignal ausgewertet werden muss.

Die vorliegende Erfindung wird nachfolgend näher unter Bezugnahme auf die beigefügte Zeichnung anhand bevorzugter Ausführungsbeispiele erläutert.

Figur 1 zeigt ein vereinfachtes Blockschaltbild einer Sendepfadstruktur eines Mobilfunksenders, in dem die vorliegende Erfindung realisiert sein kann,

Figur 2 zeigt ein vereinfachtes Blockschaltbild der Sendepfadstruktur eines Mobilfunksenders gemäß einem weiteren Ausführungsbeispiel der vorliegenden Erfindung,

Figur 3 zeigt ein vereinfachtes Blockschaltbild der Sendepfadstruktur eines Mobilfunksenders gemäß einem nochmals weiteren Ausführungsbeispiel der vorliegenden Erfindung,

Figur 4 zeigt einen Bitratenanpassungsalgorithmus gemäß einem bevorzugten Ausführungsbeispiel der vorliegenden Erfindung,

Figur 5A-5C zeigen mögliche Belegungen von Deinterleavern, welche gemäß weiteren Ausführungsbeispielen der vorliegenden Erfindung in Übereinstimmung mit entsprechend ausgestalteten Interleavern zur Anwendung kommen können, und

Figur 6 zeigt die Signalkonstellation für eine 16QAM-Modulation.

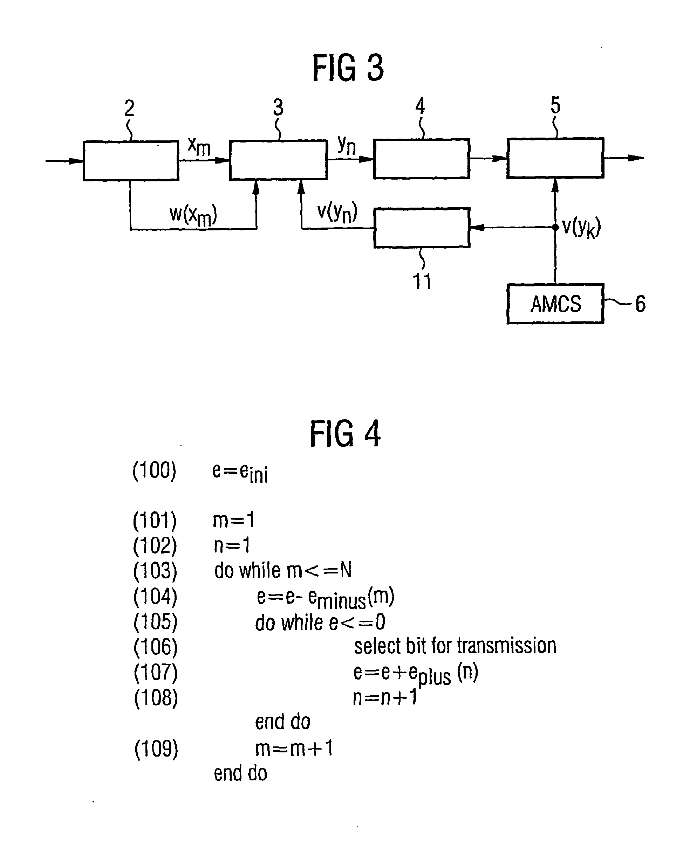

In Figur 4 ist ein Bitratenanpassungsalgorithmus gemäß einem bevorzugten Ausführungsbeispiel dargestellt, wie er beispielsweise in der Bitratenanpassungseinrichtung 3 des in Figur 1 dargestellten Senders zur Anwendung kommen kann. Hinsichtlich der Funktion und Wirkungsweise der einzelnen in Figur 1 dargestellten Komponenten sei an dieser Stelle ergänzend auf die vorhergehenden Ausführungen verwiesen.

Der Bitratenanpassungsalgorithmus basiert auf der Berechnung eines Fehlerwerts e, der ein Maß für die Abweichung zwischen der augenblicklichen Punktierungs- bzw. Repetierungsrate und der gewünschten Punktierungs- bzw. Repetierungsrate ist, wobei bei dem in Figur 4 dargestellten Bitratenanpassungsalgorithmus zwei Aktualisierungsparameter $e_{minus}$ und $e_{plus}$ zur Anwendung kommen, mit deren Hilfe der Fehlerwert entweder um $e_{minus}$ verringert oder um $e_{plus}$ erhöht wird. Durch Auswertung des auf diese Weise jeweils aktualisierten Fehlerwerts e wird beurteilt, ob (und wenn ja wie oft) das jeweilige Bit übertragen werden soll oder nicht.

Dabei wird davon ausgegangen, dass jedem der Bitratenanpassungseinrichtung 3 zugeführten Bit $x_m$ eine bestimmte Wichtigkeit bzw. Priorität $w(x_m)$ zugeordnet ist, welche die Relevanz des jeweiligen Bits zur Decodierung und Wiedergewinnung einer entsprechenden Nachricht auf der Empfängerseite repräsentiert. Je größer der Wert $w(x_m)$ eines Bits $x_m$ ist, desto größer ist die Wichtigkeit des entsprechenden Bits. Die Wichtigkeit der einzelnen Bits $x_m$ kann somit insbesondere bei Turbocodierern unterschiedlich sein, da bekanntermaßen die von Turbocodierern gelieferten systematischen Bits wichtiger für die Decodierbarkeit der entsprechenden Nachricht sind als die weniger wichtigen Paritätbits. Bei einem Faltungscodierer tragen beispielsweise die Bits am Anfang und am Ende einen geringeren Informationsgehalt und können daher mit einer geringeren Wichtigkeit versehen werden. Die Summe der Wichtigkeiten der einzelnen Bits eines N Bits umfassenden Datenpakets ergibt dabei einen Parameter K:

$$(1) \qquad \sum_{m=1}^{N} w(x_m) = K$$

Umgekehrt wird davon ausgegangen, dass für jedes übertragene Bit, d.h. jedes von der Bitratenanpassungs- einrichtung 3 ausgegebene Bit $y_n$, eine Zuverlässigkeit oder Qualität $v(y_n)$ definiert ist, welche der Sicherheit entspricht, mit welcher der Informationsgehalt des Bits übermittelt werden kann. Wie bereits zuvor anhand von Figur 6 erläutert worden ist, werden in der Regel durch die von dem in Figur 1 gezeigten Modulator 5 durchgeführte Modulation mehrere Bits einem bestimmten Symbol zugeordnet, wobei jedoch die Zuverlässigkeit bzw. Sicherheit der einzelnen Bits innerhalb dieser Symbole nicht identisch ist, sondern manche Bits können sicherer übertragen werden als andere. Darüber hinaus können die Bits mit unterschiedlicher Leistung übertragen werden, die Störleistung kann zum Zeitpunkt der Aussendung der Bits unterschiedlich sein oder die einzelnen Bits können unterschiedlich weit von einer Trainingssequenz oder von Pilotsymbolen, welche zur Kanalschätzung dienen, entfernt sein bzw. aufgrund anderer Umstände unterschiedliche Zuverlässigkeiten aufweisen. Jedem Ausgangsbit der Bitratenanpassungseinrichtung 3, d.h. jedem zu übertragenden Bit $y_n$, ist somit ein bitspezifischer Wert $v(y_n)$ zugeordnet, wobei die Zuverlässigkeit des Ausgangsbits $y_n$ zunimmt, je größer der Wert von $v(y_n)$ ist. Die Summe der Zuverlässigkeiten aller Nc Bits eines von der Bitratenanpassungseinrichtung 3 ausgegebenen Datenpakets ergibt dabei einen Parameter L:

$$(2) \qquad \sum_{n=1}^{Nc} v(y_n) = L$$

In Abhängigkeit von den in den obigen Formeln (1) und (2) definierten Zusammenhängen ist für jedes Eingangsbit $x_m$ ein bitspezifischer Aktualisierungsparameter $e_{minus}(m)$ wie folgt definiert:

$$(3) \qquad e_{minus}(m) = w(x_m) \cdot L$$

Ebenso ist für jedes Ausgangsbit $y_n$ der Bitratenanpassungseinrichtung 3, d.h. für jedes zu übertragende Bit, ein bitspezifischer Aktualisierungsparameter $e_{plus}(n)$ wie folgt definiert:

$$(4) \qquad e_{plus}(n) = v(y_n) \cdot K$$

Diese bitspezifischen Aktualisierungsparameter werden bei dem in Figur 4 gezeigten Bitratenanpassungsalgorithmus wie folgt verwendet:
In einem Schritt 100 wird zunächst der Fehlerwert e auf einen Anfangswert $e_{ini}$ gesetzt, welcher den Fehler zwischen der augenblicklichen und der gewünschten Punktierungs-/Repetierungsrate zu Beginn des Verfahrens darstellt. Dieser Anfangswert $e_{ini}$ besitzt üblicherweise der Einfachheit halber den Wert 1. Anschließend wird in einem Schritt 101 der Index des augenblicklich betrachteten Bits auf 1 gesetzt, während in einem Schritt 102 der Index des für das jeweilige Datenpaket von der Bitratenanpassungseinheit 3 ausgegebenen Bits ebenfalls auf den Index 1 gesetzt wird. Anschließend wird der in einer WHILE-Schleife 103 eingebettete Ablauf für sämtliche N Bits des jeweiligen Datenpakets ausgeführt. Dabei wird in einem Schritt 104 für das Bit $x_m$ der Fehlerwert e aktualisiert, wobei hierzu die Differenz zwischen dem augenblicklichen Fehlerwert und dem für das jeweilige Bit $x_m$ spezifischen Aktualisierungsparameter $e_{minus}(m)$ berechnet wird. Ist das Ergebnis $e \leq 0$ (Schritt 105), wird das entsprechende Bit $x_m$ für die Übertragung ausgewählt und von der Bitratenanpassungseinrichtung 3 somit zur Übertragung freigegeben bzw. an den Interleaver 4 ausgegeben (Schritt 106). Anschließend wird der entsprechende Fehlerwert e um den für das jeweilige zu übertragende Bit bzw. für das jeweilige Ausgangsbit spezifischen Aktualisierungsparameter $e_{plus}(n)$ erhöht (Schritt 107) und der Index des Ausgangsbits inkrementiert (Schritt 108). Aus Figur 4 ist ersichtlich, dass durch die Schritte 105-108 das entspre-

chende Bit $x_m$ sooft für die Übertragung ausgewählt und der entsprechende Fehlerwert um $e_{plus}(n)$ erhöht wird, bis der Fehlerwert e einen Wert größer als Null erreicht hat. Dies bedeutet, dass das Bit $x_m$ überhaupt nicht für die Übertragung ausgewählt und somit punktiert wird, falls der im Schritt 104 aktualisierte Fehlerwert e bereits vor Durchführung der Schleife mit den Schritten 105-108 größer als Null ist. Andererseits wird für den Fall, dass nach dem Schritt 104 der Fehlerwert e $\leq$ 0 ist, das Bit $x_m$ genauso oft repetiert, wie der Fehlerwert e bis zum Erreichen des Werts Null um $e_{plus}$ (n) vergrößert werden kann. Nach Abschluss der Schleife mit den Schritten 105-108 wird der Index m des Eingangsbits der Bitratenanpassungseinrichtung 3 erhöht (Schritt 109) und das Verfahren für das neue Eingangsbit beginnend bei dem Schritt 104 erneut durchgeführt.

Bei dem in Figur 4 gezeigten Bitratenanpassungsalgorithmus kann durch Variation der Parameter $e_{minus}$ und $e_{plus}$ gesteuert werden, in welchen Bereichen Bits punktiert und in welchen Bereichen Bits repetiert werden sollen. Eine Punktierung findet allgemein in denjenigen Bereichen statt, wo gilt $e_{minus} < e_{plus}$, während umgekehrt eine Repetierung dort durchgeführt wird, wo gilt $e_{minus} \geq e_{plus}$.

Der Aktualisierungsparameter $e_{plus}$ kann proportional zum Informationsgehalt oder zur Übertragungsqualität des jeweiligen Ausgangsbits der Bitratenanpassungseinrichtung 3 gewählt werden.

Zur Realisierung des zuvor erläuterten Bitratenanpassungsalgorithmus muss der Bitratenanpassungseinrichtung 3 bereits beim Ausführen des Bitratenanpassungsalgorithmus die Zuverlässigkeit bzw. Qualität $v(y_n)$ der zur Übertragung verwendeten Bits $y_n$, d.h. beispielsweise das "Gray Mapping"-Schema des jeweils vorgesehenen Modulators 5 zur Abbildung der zu übertragenden Bits auf die entsprechenden Symbole, bekannt sein. Dies kann insofern problematisch sein, da zwischen der Bitratenanpassungseinrichtung 3 und dem Modulator 5 üblicherweise der in Figur 1 dargestellte Interleaver 4 vorgesehen ist, welcher eine zeitliche Umordnung der von der Bitratenanpassungseinrichtung 3 ausgegebenen Bitfolge vornimmt. Dieses Problem ist jedoch lösbar, falls der Einfluss des Interleavers 4 berücksichtigt wird. Zur Vereinfachung könnten jedoch für jede Bitklasse, in welcher Bits mit gleicher Zuverlässigkeit $v(y_n)$ bzw. Qualität zusammengefasst sind, separate Interleaver 4a, 4b verwendet werden, wie es bereits zuvor anhand Figur 2 erläutert worden ist. Bei einer 16QAM-Modulation (vergleiche Figur 6) wären demzufolge lediglich zwei separate Interleaver 4a, 4b erforderlich, da es lediglich zwei unterschiedliche Zuverlässigkeiten der einzelnen Bitpositionen innerhalb der in Figur 6 dargestellten Symbole und somit zwei unterschiedliche Bitklassen gibt. Da jeder Interleaver 4a, 4b in diesem Fall jeweils einer Bitklasse zugeordnet ist, ist der Bitratenanpassungseinrichtung 3 implizit die Zuverlässigkeit der Bits der beiden Ausgangsbitströme bekannt.

Sollen hingegen keine getrennten Interleaver verwendet werden, kann im allgemeinen Fall die Abfolge der Zuverlässigkeiten $v(y_n)$ am Ausgang des Kanalcodierers 2 durch Deinterleaving mit Hilfe eines Deinterleavers 11 aus den bekannten Zuverlässigkeiten $v(y_k)$ der jeweils verwendeten Modulationsart berechnet werden, wobei n den Index der von der Bitratenanpassungseinrichtung 3 ausgegebenen Bits und k den Bitindex nach dem Interleaver 4 bezeichnet. Ein entsprechendes Ausführungsbeispiel ist in Figur 3 dargestellt, wobei die Wichtigkeiten bzw. Prioritäten $w(x_m)$ der Eingangsbits $x_m$ der Bitratenanpassungseinrichtung 3 aus dem Kanal- bzw. Turbocodierer 2 abgeleitet werden können.

Eine explizite Deinterleaving-Operation kann vermieden werden, falls in dem in Figur 4 gezeigten Interleaver 4 zumindest in Bezug auf die Zuordnung der einzelnen Ausgangsbits der Bitratenanpassungseinrichtung 3, welche unterschiedliche Zuverlässigkeiten aufweisen, eine einfache Zuordnungsregel implementiert ist.

Die einfachste Realisierung dieses Prinzips ist es, wenn durch die Funktion des Interleavers 4 die Reihenfolge der Bits mit unterschiedlichen Zuverlässigkeiten, d.h. die Reihenfolge der unterschiedlichen Bitklassen, unverändert bleibt. Treten bei der Modulation durch den Modulator 5, beispielsweise bei einer 16QAM-Modulation, abwechselnd Bits mit niedriger und hoher Zuverlässigkeit auf, ist dies demzufolge auch vor dem Interleaver 4 der Fall, so dass die Bitratenanpassungseinrichtung 3 leicht aufgrund der Reihenfolge der Bitausgabe bzw. aufgrund des Bitindex n auf die jeweils inhärente Zuverlässigkeit $v(y_n)$ schließen kann. Dies lässt sich bei dem derzeit für UMTS-Mobilfunksyteme verwendeten Blockinterleaver mit Spaltenvertauschung, bei dem die einzelnen Bits zeilenweise eingeschrieben und spaltenweise ausgelesen werden, relativ leicht realisieren, wenn die Anzahl der Spalten zu der Anzahl der unterschiedlichen Zuverlässigkeit in Abhängigkeit von der jeweils gewählten Modulationsart teilerfremd ist. Ist zusätzlich auch die Anzahl der Zeilen des Blockinterleavers mit der Anzahl der unterschiedlichen Zuverlässigkeiten, d.h. der Anzahl der Bitklassen, teilerfremd, lässt sich bei geeigneter Spaltenvertauschung eine Zuordnung erreichen, bei welcher die Reihenfolge der Modulationsbits immer alternierend ist, während sie ansonsten innerhalb einer Spalte des Interleavers alternierend ist, d.h. es gibt nur wenige "Stoßstellen", wo diese festgelegte Reihenfolge durchbrochen ist. Diese wenigen "Stoßstellen" sind jedoch nicht störend, da bei geeigneter Wahl der Spaltenvertauschungsoperation die Anzahl der "Stoßstellen" gering gehalten werden kann.

Eine derartige Interleaver-Realisierung ist für das Beispiel einer 16QAM-Modulation in Figur 5A veranschaulicht, wobei in Figur 5A nicht der Interleaver 4 selbst, sondern der zugehörige Deinterleaver 11 dargestellt ist, d.h. die Eingangsdaten besitzen die Reihenfolge der Bitzuverlässigkeiten $v(y_k)$ am Modulator 5, wobei von dem Deinterleaving 11 die gesuchte Reihenfolge $v(y_n)$ der Zuverlässigkeiten für die Bitratenanpassungseinrichtung 3 ausgegeben wird. Bei dem in Figur 5A dargestellten Beispiel wird der Speicher des Deinterleavings zeilenweise gefüllt und spaltenweise ausgelesen, wobei die Zeilen in der Reihenfolge 1, 2, 3, 4, 5, 6, 7 beschrieben und die Spalten in der Reihenfolge 1, 4, 3, 2, 5 ausgelesen werden (was der zuvor erwähnten Spaltenvertauschung entspricht). Bei einer 16QAM-Modulation gibt es - wie bereits erwähnt worden ist - lediglich zwei Bitklassen mit unterschiedlicher Zuverlässigkeit, wobei die zuverlässigen Bitpositionen in Figur 5 mit H ("High Reliability") und die weniger zuverlässigen mit L ("Low Reliability") bezeichnet sind. Am Modulator 5 wird jeweils eine Sequenz von zwei H-Bits und zwei L-Bits zu einem Modulationssymbol zusammengefasst. Bei dem in Figur 5A gezeigten Beispiel ist die Anzahl der unterschiedlichen Bitklassen (zwei) und die Anzahl der Zeilen (sieben) und die Anzahl der Spalten (fünf) teilerfremd. Werden die Spalten - wie zuvor angegeben - in der Reihenfolge 1, 4, 3, 2, 5 ausgelesen, ergibt sich sowohl vor als auch nach dem Interleaver 4 die alternierende Sequenz von jeweils zwei H-Bits und zwei L-Bits. D.h. die Funktionalität des Interleavers 4 ist transparent und die Zuordnung der einzelnen Zuverlässigkeiten $v(y_n)$ zu den einzelnen Ausgangsbits der Bitratenanpassungseinrichtung 3 sehr einfach möglich.

Ein ähnliches Beispiel ist in Figur 5B dargestellt, wobei in dem dort dargestellten Beispiel anstelle von sieben Zeilen acht Zeilen vorgesehen sind, so dass die zuvor beschriebene Teilerfremdheit nicht mehr vorhanden ist. Werden die einzelnen Spalten in der Reihenfolge 1, 5, 2, 3, 4 ausgelesen, kann die alternierende Sequenz von jeweils zwei H-Bits und zwei L-Bits nicht exakt eingehalten werden. Allgemein existiert keine Lesereihenfolge mehr, für welche diese vorgegebene alternierende Sequenz exakt erhalten bleibt. Innerhalb einer Spalte bleibt jedoch die alternierende Sequenz erhalten, wobei lediglich an den "Stoßstellen" zweier Spalten (z.B. zwischen den Spalten 5 und 2, zwischen den Spalten 2 und 3 und zwischen den Spalten 3 und 4) Unregelmäßigkeiten auftreten.

Eine andere einfache Zuordnung sieht vor, dass Bits $y_n$ mit gleicher Zuverlässigkeit $v(y_n)$ unmittelbar nacheinander kommen. Dies lässt sich erreichen, wenn die Anzahl der Spalten des Interleavers 4 durch die Anzahl der unterschiedlichen Bitklassen, in welchen die Bits mit unterschiedlichen Zuverlässigkeiten zusammengefasst sind, teilbar ist. Zusätzlich kann auch die Spaltenvertauschung des Interleavers 4 derart gewählt werden, dass eine derartige Zuordnung erreicht wird.

Ein entsprechendes Beispiel ist in Figur 5C dargestellt, wobei wiederum nicht der Interleaver 4, sondern der zugehörige Deinterleaver 11 dargestellt ist. Die Anzahl der Spalten (acht) ist durch die Anzahl der unterschiedlichen Bitklassen (zwei bei einer 16QAM-Modulation) teilbar. Durch eine geeignete Lesereihenfolge, beispielsweise durch Lesen der Spalten in der Reihenfolge 1, 5, 2, 6, 3, 7, 4, 8, kann eine Gruppierung der H- und L-Bits erreicht werden, so dass ebenfalls für die Bitratenanpassungseinrichtung 3 in Abhängigkeit von dem Index n des jeweils ausgegebenen und zur Übertragung vorgesehenen Bits sowie aufgrund der Kenntnis der Interleaverstruktur einfach auf die zugehörige Bitzuverlässigkeit $v(y_n)$ geschlossen werden kann.

Mit Hilfe der vorliegenden Erfindung kann somit - wie ausführlich zuvor beschrieben worden ist - sowohl die Wichtigkeit bzw. Priorität der einzelnen Bits $x_m$ desjenigen Bitstroms, welcher einer Bitratenanpassung unterzogen werden soll, als auch die Zuverlässigkeit bzw. Qualität der Bits $y_n$, welche nach Durchführung der Bitratenanpassung zur Übertragung vorgesehen sind, bei der Bitratenanpassung berücksichtigt werden, um in Abhängigkeit von den jeweiligen Betriebs- bzw. Übertragungsbedingungen eine jeweils optimale Bitratenanpassung durchzuführen.

Dabei kann insbesondere bei Kommunikationssystemen mit ARQ-Verfahren, bei welchen ein fehlerhafter Empfang des Datenpakets von dem Empfänger zur erneuten Übertragung von dem Sender angefordert wird, die Wichtigkeit bzw. Priorität der einzelnen Bits $x_m$ in Abhängigkeit davon gewählt werden, zum wievielten Mal das entsprechende Datenpaket übertragen wird. Dies ist insbesondere deshalb interessant, da bei einer Turbocodierung die systematischen Bits bei der ersten Übertragung wichtiger sind als die Paritätbits, während bei einer Wiederholung dieser Übertragung dieser Unterschied geringer ausfällt oder sogar die Paritätbits wichtiger sein können. Mit dieser Maßnahme kann auch erreicht werden, dass für jede Übertragung eines Datenblocks (teilweise) unterschiedliche Bits verwendet werden. Dabei können durch die vorliegende Erfindung sowohl sogenannte IR-Verfahren ("Incremental Redundancy"), bei welchen die wiederholt gesendeten Datenpakete mit dem ursprünglich gesendeten Datenpaket lediglich teilweise identisch sind, als auch sogenannte "Chase Combining"-Verfahren, bei welchen die Bits sämtlicher Wiederholungsdatenpakete mit dem ursprünglichen Datenpaket identisch sind, realisiert werden. Wird bevorzugt anstelle einer Punktierung eine Repetierung verwendet, können zwar mit Hilfe der zuvor vorgeschlagenen Maßnahme stets dieselben Bits gesendet, jedoch in den unterschiedlichen Übertragungen des jeweiligen Datenblocks (teilweise) unterschiedliche Bits repetiert werden. Ein zusätzlicher Speicherplatz wird somit nicht benötigt.

**Patentansprüche**

1. Verfahren zur Anpassung der Bitrate eines in einem Kommunikationssystem zu übertragenden Bitstroms, bei dem die Bits (x) des zu übertragenden Bitstroms zur Anpassung der Bitrate derart tatsächlich für die Übertragung verwendeten Bits (y) zugeordnet werden, dass jeweils für eine bestimmte Anzahl (N) aufeinander folgender Bits (x) des zu übertragenden Bitstroms die Summe von Wichtigkeiten (w), welche die jeweiligen Bits (x) des Bitstroms für eine Wiedergewinnung einer das jeweilige Bit enthaltenden Nachricht aufweisen, in einem vorgegebenen Verhältnis zu der Summe von Zuverlässigkeiten (v) der entsprechenden tatsächlich für die Übertragung verwendeten Bits (y), mit welchen diese Bits nach Durchführung der Bitratenanpassung einen bestimmten Informationsgehalt übermitteln können, stehen, bei dem die Anpassung der Bitrate durch Punktieren oder Repetieren der Bits (x) des Bitstroms erfolgt, wobei bei der Punktierung bestimmte Bits entfernt bzw. bei der Repetierung bestimmte Bits vervielfacht werden, wobei eine Punktierungs- bzw. Repetierungsrate, mit welcher die Bits (x) des Bitstroms zur Bitratenanpassung punktiert bzw. repetiert werden, erhöht bzw. erniedrigt wird, wenn ein Quotient aus der Summe der Wichtigkeiten (w) der bestimmten Anzahl (N) aufeinander folgender Bits (x) des Bitstroms und der Summe der Zuverlässigkeiten (v) der entsprechenden tatsächlich für die Übertragung verwendeten Bits (y) größer als ein vorgegebener Schwellenwert ist, und

wobei die Punktierungs- bzw. Repetierungsrate, mit welcher die Bits (x) des Bitstroms zur Bitratenanpassung punktiert bzw. repetiert werden, erniedrigt bzw. erhöht wird, wenn der Quotient kleiner als der vorgegebene Schwellenwert ist.

**2.** Verfahren nach Anspruch 1,
**dadurch gekennzeichnet ,**
**dass** für jedes Bit (x) ein aktualisierter Fehlerwert (e), der ein Maß für die Abweichung zwischen der augenblicklichen Punktierungs- bzw. Repetierungsrate und einer gewünschten Punktierungs- bzw. Repetierungsrate ist, auf Grundlage eines entsprechenden bereits zuvor ermittelten Fehlerwerts und mindestens eines variablen Aktualisierungsparameters ($e_{plus}$) bestimmt und anhand des somit aktualisierten Fehlerwerts (e) beurteilt wird, ob das entsprechende Bit (x) punktiert bzw. repetiert werden soll oder nicht, und
**dass** der variable Aktualisierungsparameter ($e_{plus}$) jeweils in Abhängigkeit von der Zuverlässigkeit (v) gewählt wird, mit welcher das jeweilige Bit nach Durchführung der Bitratenanpassung einen bestimmten Informationsgehalt übermitteln kann.

**3.** Verfahren nach Anspruch 2,
**dadurch gekennzeichnet ,**
**dass** für die Bestimmung des aktualisierten Fehlerwerts (e) ein weiterer variabler, bitspezifischer Aktualisierungsparameter ($e_{minus}$) verwendet wird, welcher für jedes Bit (x) des Bitstroms in Abhängigkeit von der Wichtigkeit (w) gewählt wird, welche das jeweilige Bit (x) des Bitstroms für die Wiedergewinnung der das jeweilige Bit enthaltenden Nachricht aufweist.

**4.** Verfahren nach Anspruch 3,
**dadurch gekennzeichnet ,**
**dass** der Bitstrom vor Durchführung der Bitratenanpassung einer Kanalcodierung (2) unterzogen wird, wobei die Wichtigkeit (w) einer Wichtigkeit entspricht, welche das jeweilige Bit (x) für die Decodierung der das jeweilige Bit (x) enthaltenen Nachricht hat.

**5.** Verfahren nach Anspruch 3 oder 4,
**dadurch gekennzeichnet ,**
**dass** bei einer Bitratenanpassung eines N Bits (x) umfassenden Datenpakets die Summe der Wichtigkeiten (w) der Bits (x) dieses Datenpakets einem Wert K entspricht,
**dass** bei einer Ausgabe von Nc zur Übertragung vorgesehenen Bits (y) nach Durchführung der Bitratenanpassung auf Grundlage dieses Datenpakets die Summe der Zuverlässigkeiten (v) sämtlicher Nc ausgegebener Bits (y) einem Wert L entspricht, und
**dass** als Aktualisierungsparameter ($e_{plus}$) für ein ausgegebenes Bit Nr. n das Produkt aus dem Wert der Zuverlässigkeit (v), mit welcher das Bit Nr. n einen bestimmten Informationsgehalt übermitteln kann, und dem Wert K verwendet wird, während als weiterer Aktualisierungsparameter ($e_{minus}$) für ein Bit Nr. m des Bitstroms das Produkt aus dem Wert der Wichtigkeit (w) des Bits Nr. m und dem Wert L verwendet wird.

**6.** Verfahren nach einem der Ansprüche 3 - 5,
**dadurch gekennzeichnet ,**
**dass** der aktualisierte Fehlerwert (e) jedes Bits (x) aus der Differenz zwischen dem entsprechenden bereits zuvor ermittelten Fehlerwert und dem weiteren Aktualisierungsparameter ($e_{minus}$) bestimmmt wird, und
**dass** für den Fall, dass der somit aktualisierte Fehlerwert (e) nicht größer als ein bestimmter Referenzwert ist, das entsprechende Bit (x) solange für eine Übertragung ausgewählt und anschließend der für dieses Bit (x) aktualisierte Fehlerwert (e) jeweils nochmals durch die Summenbildung mit dem Aktualisierungsparameter ($e_{plus}$) aktualisiert wird, bis der daraus resultierenden Fehlerwert (e) größer als der Referenzwert ist.

**7.** Verfahren nach Anspruch 6,

**dadurch gekennzeichnet ,**
**dass** der Referenzwert Null ist.

8.  Verfahren nach einem der Ansprüche 3 - 7,
    **dadurch gekennzeichnet ,**
    **dass** nach der Bitratenanpassung die Bits an einen Empfänger übertragen werden, welcher bei einem fehlerhaften Empfang eines die entsprechenden Bits umfassenden Datenpakets eine erneute Übertragung des jeweiligen Datenpakets anfordert,
    wobei die Wichtigkeit (w) der Bits (x) des Bitstroms, welcher der Bitratenanpassung unterzogen wird, in Abhängigkeit davon gewählt wird, zum wievielten Mal das Datenpaket, zu dem die entsprechenden Bits (x) gehören, übertragen wird.

9.  Verfahren nach einem der vorhergehenden Ansprüche,
    **dadurch gekennzeichnet ,**
    **dass** nach der Bitratenanpassung (3) ein Interleaving (4) der nach der Bitratenanpassung tatsächlich zur Übertragung vorgesehenen Bits (y) durchgeführt wird, wobei für jede Gruppe von Bits, in welcher zur Übertragung vorgesehene Bits (y) mit jeweils einer identischen Zuverlässigkeit (v) zusammengefasst sind, ein separater Interleavingvorgang durchgeführt wird, so dass zur Durchführung der Bitratenanpassung für jedes zur Übertragung vorgesehene Bit (y) die entsprechende Zuverlässigkeit daraus abgeleitet werden kann, welchem Interleavingvorgang das entsprechende Bit (y) zugeführt wird.

10. Verfahren nach einem der Ansprüche 1 - 8,
    **dadurch gekennzeichnet ,**
    **dass** die Zuverlässigkeiten (v) für die einzelnen nach Durchführung der Bitratenanpassung tatsächlich zur Übertragung vorgesehenen Bits (y) aus bekannten Zuverlässigkeiten, mit welchen die entsprechenden Bits bei einer Modulation (5) auf entsprechende zu übertragende Modulationssymbole (13) abgebildet werden, abgeleitet werden.

11. Verfahren nach Anspruch 10,
    **dadurch gekennzeichnet ,**
    **dass** nach der Bitratenanpassung (3) und vor der Modulation (5) ein Interleaving (4) durchgeführt wird, wobei die Zuverlässigkeiten (v) der von der Bitratenanpassung (3) ausgegebenen und tatsächlich für die Übertragung vorgesehenen Bits (y) aus den bekannten Zuverlässigkeiten der Modulation (5) durch Deinterleaving (11) abgeleitet werden.

12. Verfahren nach einem der Ansprüche 1 - 8,
    **dadurch gekennzeichnet ,**
    **dass** nach der Bitratenanpassung (3) ein Interleaving (4) derart durchgeführt wird, dass durch das Interleaving die Reihenfolge der tatsächlich zur Übertragung vorgesehenen Bits (y) hinsichtlich ihrer Zuverlässigkeiten (v) unverändert bleibt, so dass zur Durchführung der Bitratenanpassung die Zuverlässigkeit (v) für die nach der Bitratenanpassung zur Übertragung vorgesehenen Bits (y) aus einem Index (n), mit welchem das jeweilige Bit (y) von der Bitratenanpassung (3) ausgegeben wird, abgeleitet werden kann.

13. Verfahren nach Anspruch 12,
    **dadurch gekennzeichnet ,**
    **dass** für das Interleaving ein Blockinterleaver mit Spalten und Zeilen verwendet wird, wobei die Anzahl der Spalten des Blockinterleavers (4) mit der Anzahl der unterschiedlichen Zuverlässigkeiten (v) der Bits (y) teilerfremd ist.

14. Verfahren nach Anspruch 13,
    **dadurch gekennzeichnet ,**
    **dass** die Anzahl der Zeilen des Blockinterleavers (4) mit der Anzahl der unterschiedlichen Zuverlässigkeiten (v) teilerfremd ist.

15. Verfahren nach einem der Ansprüche 1 - 8,
    **dadurch gekennzeichnet ,**
    **dass** nach der Bitratenanpassung (3) ein Interleaving (4) derart durchgeführt wird, dass stets eine bestimmte Anzahl von Bits (y) mit gleicher Zuverlässigkeit (v) von dem Interleaving zur Übertragung ausgegeben wird, so dass zur Durchführung der Bitratenanpassung die Zuverlässigkeit (v) des jeweils tatsächlich zu übertragenden Bits (y) aus einem Index (n), mit dem das jeweilige Bit (y) von der Bitratenanpassung ausgegeben wird, abgeleitet werden kann.

**16.** Verfahren nach Anspruch 15,
**dadurch gekennzeichnet ,**
**dass** das Interleaving mit einem Blockinterleaver (4) mit Zeilen und Spalten durchgeführt wird, wobei die Anzahl der Spalten des Blockinterleavers (4) durch die Anzahl der unterschiedlichen Zuverlässigkeiten (v) teilbar ist.

**17.** Kommunikationsvorrichtung zum Übertragen eines Bitstroms über einen Übertragungskanal,
mit einer Bitratenanpassungseinrichtung (3) zur Anpassung der Bitrate des zu übertragenden Bitstroms, wobei dass die Bitratenanpassungseinrichtung (3) die Bits (x) des zu übertragenden Bitstroms zur Anpassung der Bitrate derart tatsächlich für die Übertragung verwendeten Bits (y)
zuordnet, dass jeweils für eine bestimmte Anzahl (N) aufeinander folgender Bits (x) des zu übertragenden Bitstroms die Summe von Wichtigkeiten (w), welche die jeweiligen Bits (x) des Bitstroms für eine Wiedergewinnung einer das jeweilige Bit enthaltenden Nachricht aufweisen, in einem vorgegebenen Verhältnis zu der Summe von Zuverlässigkeiten (v) der entsprechenden tatsächlich für die Übertragung verwendeten Bits (y), mit welchen diese Bits nach Durchführung der Bitratenanpassung einen bestimmten Informationsgehalt übermitteln können, stehen,
wobei die Anpassung der Bitrate durch Punktieren oder Repetieren der Bits (x) des Bitstroms erfolgt, wobei bei der Punktierung bestimmte Bits entfernt bzw. bei der Repetierung bestimmte Bits vervielfacht werden,
wobei eine Punktierungs- bzw. Repetierungsrate, mit welcher die Bits (x) des Bitstroms zur Bitratenanpassung punktiert bzw. repetiert werden, erhöht bzw. erniedrigt wird, wenn ein Quotient aus der Summe der Wichtigkeiten (w) der bestimmten Anzahl (N) aufeinander folgender Bits (x) des Bitstroms und der Summe der Zuverlässigkeiten (v) der entsprechenden tatsächlich für die Übertragung verwendeten Bits (y) größer als ein vorgegebener Schwellenwert ist, und
wobei die Punktierungs- bzw. Repetierungsrate, mit welcher die Bits (x) des Bitstroms zur Bitratenanpassung punktiert bzw. repetiert werden, erniedrigt bzw. erhöht wird, wenn der Quotient kleiner als der vorgegebene Schwellenwert ist.

**18.** Kommunikationsvorrichtung nach Anspruch 17,
**dadurch gekennzeichnet ,**
**dass** die Kommunikationsvorrichtung (1) bzw. die Bitratenanpassungseinrichtung (3) zur Durchführung des Verfahrens nach einem der Ansprüche 1-16 ausgestaltet ist.

**19.** Kommunikationsvorrichtung nach Anspruch 17 oder 18,
**dadurch gekennzeichnet ,**
**dass** die Kommunikationsvorrichtung ein Mobilfunksender ist.

**Claims**

**1.** Method for matching the bit rate of a bit stream to be transmitted in a communication system, in which the bits (x) of the bit stream to be transmitted will be assigned for matching of the bit rate in such a way to the bits actually used for a transmission (y), that for a specific number (N) of consecutive bits (x) of the bit stream to be transmitted in each case the sum of the importances (w), which the relevant bits (x) of the bit stream exhibit for a recovery of a message containing the relevant bit is in a specified relationship to the sum of reliabilities (v) of the corresponding bits actually used for the transmission (y), with which these bits after executing bit rate matching can transmit a specific information content, in which case the bit rate is matched by puncturing or repeating the bits (x) of the bit stream, in which case with puncturing specific bits are removed or with repeating specific bits are multiplexed, in which case a puncturing or repetition rate with which the bits (x) of the bit stream are punctured or repeated for bit rate matching is increased or decreased when a quotient of the sum of the importances (w) of the defined number (N) of consecutive bits (x) of the bit stream and the sum of the reliabilities (v) of the corresponding bits actually used for the transmission (y) is greater than a specified threshold value and
in which case the puncturing or repetition rate with which the bits (x) of the bit stream of punctured or repeated for bit rate matching is decreased or increased when the quotient is smaller than the specified threshold value.

**2.** Method in accordance with claim 1,
**characterized in that**,
for each bit (x) an updated error value (e) which is a measure of the deviation between the current puncturing or repetition rate and a desired puncturing or repetition rate is the basis of a corresponding error value already previously determined and is determined by at least one variable updating parameter ($e_{plus}$) and on the basis of the error value thus updated (e) an assessment is made as to whether the corresponding bit (x) is to be punctured or repeated, and

that the variable updating parameter ($e_{plus}$) will be selected in each case depending on the reliability (v) with which the relevant bit can transmit a specific information content after execution of bit rate matching.

3. Method in accordance with claim 2,
   **characterized in that**,
   for determining the updated error value (e), a further bit-specific updating parameter ($e_{minus}$) will be used which is selected for each bit (x) of the bit stream depending on the importance (w) which the relevant bit (x) of the bit stream has for recovery of the message containing the relevant bit.

4. Method in accordance with claim 3,
   **characterized in that**,
   the bit stream is subjected to channel coding (2) before execution of the bit rate matching (2), in which case the importance (w) corresponds to an importance which the relevant bit (x) has for the decoding of the message containing the relevant bit (x).

5. Method in accordance with claim 3 or 4,
   **characterized in that**,
   for bit rate matching of a data packet comprising N bits (x) the sum of the importances (w) of the bits (x) of this data packet corresponds to a value K, that for output of Nc bits provided for transmission (y) after execution of the bit rate matching on the basis of this data packet the sum of the reliabilities n (v) of all Nc output bits (y) corresponds to a value L, and
   that as updating parameter ($e_{plus}$) for an output bit no. n the product of the value of the reliability (v) with which bit no. n can transfer a specific information content and the value K is used, whereas as a further updating parameter ($e_{minus}$) for a bit no. m of the bit stream the product of the value of the importance (w) of bit no. m and the value L will be used.

6. Method in accordance with one of the claims 3-5,
   **characterized in that**,
   the updated error value (e) of each bit (x) is determined from the difference between the corresponding error value already determined previously and the further updating parameter ($e_{minus}$), and
   that for the case where the error value updated in this way (e) is not greater than a specific reference value, the corresponding bit (x) is selected for a transmission and subsequently the updated error value (e) for this bit (x) is updated in each case again by forming the sum with the updating parameter ($e_{plus}$) until the resulting error value (e) is greater than the reference value.

7. Method in accordance with claim 6,
   **characterized in that**,
   the reference value is zero.

8. Method in accordance with one of the claims 3-7,
   **characterized in that**,
   after the bit rate matching the bits are transmitted to a receiver, which on incorrectly receiving a data packet including the corresponding bits, requests a new transmission of the relevant data packet, in which case the importance (w) of the bits (x) of the bit stream which is subjected to bit rate matching is selected to depend on the number of times the data packet to which the corresponding bits (x) belong will be transmitted.

9. Method in accordance with one of the previous claims,
   **characterized in that**,
   after bit rate matching (3) an interleaving (4) of the bits (y) actually intended for transmission after bit rate matching is executed, in which case for each group of bits in which bits (y) intended for transmission are grouped together with an identical reliability (v) in each case, a separate interleaving process is executed, so that to perform the bit rate matching for each bit intended for transmission (y) of the corresponding reliability it can be derived from this bit to which the interleaving process the corresponding bit (y) will be directed.

10. Method in accordance with one of the claims 1-8,
    **characterized in that**,
    the reliabilities (v) for the individual bits (y) actually intended for transmission after execution of bit rate matching (y) can be derived from known reliabilities with which the corresponding bits are mapped with a modulation (5) to corresponding modulation symbols (13) to be transmitted.

11. Method in accordance with claim 10,
**characterized in that**,
after the bit rate matching (3) and before the modulation (5) interleaving (4) is executed, in which case the reliabilities (v) of the bits (y) output from bit rate matching (3) and actually intended for transmission will be derived from the known reliabilities of the modulation (5) by deinterleaving (11) .

12. Method in accordance with one of the claims 1-8,
**characterized in that**,
after the bit rate matching (3) interleaving (4) is performed in such a way that through the interleaving the sequence of the bits actually intended for transmission (y) remains unchanged as regards their reliabilities (v), so that to execute the bit rate matching the reliability (v) for the bits (y) intended for transmission after bit rate matching can be derived from an index (n) with which the relevant bit (y) is output by bit rate matching (3).

13. Method in accordance with claim 12,
**characterized in that**,
for interleaving a block interleaver with columns and rows is used, in which case the number of columns of the block interleaver (4) is indivisible by the number of different reliabilities (v) of the bits (y).

14. Method in accordance with claim 13,
**characterized in that**,
the number of rows of the block interleaver (4) is indivisible by the number of different reliabilities (v).

15. Method in accordance with one of the claims 1-8,
**characterized in that**,
after the bit rate matching (3) an interleaving (4) is performed in such a way that a specific number of bits (y) with the same reliability (v) will always be output for transmission by the interleaving so that to execute bit rate matching the reliability (v) of the actual bit to be transmitted in each case (y) can be derived from an index (n), with which the relevant bit (y) will be output by the bit rate matching.

16. Method in accordance with claim 15,
**characterized in that**,
the interleaving is performed with a block interleaver (4) with rows and columns, in which case the number of columns of the block interleaver (4) is divisible by the number of different reliabilities (v).

17. Communication device for transmission of a bit stream over a transmission channel,
with a bit rate matching device (3) for matching the bit rate of the bit stream to be transmitted, where the bit rate matching device (3) assigns the bits (x) of the bit stream to be transmitted for matching the bit rate to the bits actually used for the transmission (y) in such a way that for a specific number (N) of consecutive bits (x) of the bit stream to be transmitted in each case the sum of importances (w) which the relevant bits (x) of the bit stream exhibit for a recovery of a message containing the relevant bit is in a specified ratio to the sum of reliabilities (v) of the corresponding bits actually used for the transmission (y) with which these bits can transfer a specific information content after execution of bit rate matching.
in which case the matching of the bit rate is undertaken by puncturing or repeating the bits (x) of the bit stream, in which case puncturing removes specific bits and repetition multiplies specific bits,
in which case a puncturing or repetition rate with which the bits (x) of the bit stream are punctured or repeated for bit rate matching is increased or reduced when a quotient from the sum of the importances (w) of the specific number (N) of consecutive bits (x) of the bit stream and the sum of the reliabilities (v) of the corresponding bits actually used for the transmission (y) is greater than a specified threshold value and
in which case the puncturing or repetition rate with which the bits (x) of the bit stream are punctured or repeated for bit rate matching is increased or reduced when the quotient is less than the specified threshold value.

18. Communication device in accordance with claim 17,
**characterized in that**,
the communication device (1) or the bit rate matching device (3) is embodied for executing the method in accordance with one of the claims 1-16.

**19.** Communication device in accordance with claim 17 or 18,
**characterized in that**,
the communication device is a mobile radio receiver.

**Revendications**

**1.** Procédé d'adaptation du débit binaire d'un flux binaire devant être transmis dans un système de communication, dans lequel les bits (x) du flux binaire devant être transmis sont affectés pour l'adaptation du débit binaire de telle manière aux bits (y) effectivement utilisés pour la transmission que, pour un certain nombre (N) de bits successifs (x) du flux binaire devant être transmis, la somme d'importances (w), que présentent les bits respectifs (x) du flux binaire pour une récupération d'un message contenant le bit respectif, se trouvent dans un rapport prédéfini à la somme de fiabilités (v) des bits (y) correspondants effectivement utilisés pour la transmission, avec lesquelles ces bits peuvent transmettre un certain contenu informatif après la réalisation de l'adaptation du débit binaire, dans lequel l'adaptation du débit binaire est réalisée par poinçonnage ou répétition des bits (x) du flux binaire, certains bits étant retirés lors du poinçonnage resp. certains bits étant copiés lors de la répétition, un taux de poinçonnage resp. de répétition, avec lequel les bits (x) du flux binaire sont poinçonnés resp. répétés pour l'adaptation du débit binaire, étant augmenté resp. baissé lorsqu'un quotient, obtenu à partir de la somme des importances (w) du certain nombre (N) de bits successifs (x) du flux binaire et de la somme des fiabilités (v) des bits (y) correspondants effectivement utilisés pour la transmission, est supérieur à une valeur de seuil prédéfinie, et le débit de poinçonnage resp. de répétition, avec lequel les bits (x) du flux binaire sont poinçonnés resp. répétés pour l'adaptation du flux binaire, étant baissé resp. augmenté lorsque le quotient est inférieur à la valeur de seuil prédéfinie.

**2.** Procédé selon la revendication 1,
**caractérisé en ce**
**que** pour chaque bit (x), une valeur d'erreur actualisée (e), qui est une mesure pour l'écart entre le débit de poinçonnage resp. de répétition momentané et un débit de poinçonnage resp. de répétition souhaité, est déterminée sur la base d'une valeur d'erreur correspondante déjà déterminée auparavant et sur la base d'au moins un paramètre d'actualisation variable ($e_{plus}$) et en ce qu'il est jugé à l'aide de la valeur d'erreur (e) ainsi actualisée si le bit correspondant (x) doit être poinçonné resp. répété ou non, et
en ce que le paramètre d'actualisation variable ($e_{plus}$) est respectivement sélectionné en fonction de la fiabilité (v) avec laquelle le bit respectif peut transmettre un certain contenu informatif après la réalisation de l'adaptation du débit binaire.

**3.** Procédé selon la revendication 2,
**caractérisé en ce**
**que** pour déterminer la valeur d'erreur actualisée (e), un autre paramètre d'actualisation variable ($e_{minus}$) et spécifique au bit est utilisé, qui est sélectionné pour chaque bit (x) du flux binaire en fonction de l'importance (w), que présente le bit respectif (x) du flux binaire pour la récupération du message contenant le bit respectif.

**4.** Procédé selon la revendication 3,
**caractérisé en ce**
**que** le débit binaire est soumis à un codage canal (2) avant la réalisation de l'adaptation du débit binaire, l'importance (w) correspondant à une importance qu'a le bit respectif (x) pour le décodage du message contenant le bit respectif (x).

**5.** Procédé selon la revendication 3 ou 4,
**caractérisé**
**en ce que** lors d'une adaptation du débit binaire d'un paquet de données comprenant N bits (x), la somme des importances (w) des bits (x) de ce paquet de données correspond à une valeur K,
**en ce que**, lors d'une sortie de Nc bits (y) prévus pour la transmission, après la réalisation de l'adaptation du débit binaire sur la base de ce paquet de données, la somme des fiabilités (v) de tous les Nc bits (y) sortis correspond à une valeur L, et
**en ce que** le produit de la valeur de la fiabilité (v), avec laquelle le bit n° n peut transmettre un certain contenu informatif, et de la valeur K est utilisé en tant que paramètre d'actualisation ($e_{plus}$) pour un bit n° n sorti, alors que le produit de la valeur de l'importance (w) du bit n° m et de la valeur L est utilisé en tant qu'autre paramètre d'actualisation ($e_{minus}$) pour un bit n° m du flux binaire.

**6.** Procédé selon l'une quelconque des revendications 3 à 5,
**caractérisé**
**en ce que** la valeur d'erreur actualisée (e) de chaque bit (x) est déterminée à partir de la différence entre la valeur d'erreur correspondante déjà déterminée auparavant et l'autre paramètre d'actualisation ($e_{minus}$) , et
**en ce que**, pour le cas où la valeur d'erreur (e) ainsi actualisée n'est pas supérieure à une certaine valeur de référence, le bit correspondant (x) est sélectionné pour une transmission et ensuite la valeur d'erreur (e) actualisée pour ce bit (x) est respectivement actualisée encore une fois par la formation de somme avec le paramètre d'actualisation ($e_{plus}$), jusqu'à ce que la valeur d'erreur (e) qui en résulte soit supérieure à la valeur de référence.

**7.** Procédé selon la revendication 6,
**caractérisé en ce**
**que** la valeur de référence est zéro.

**8.** Procédé selon l'une quelconque des revendications 3 à 7,
**caractérisé en ce**
**que**, après l'adaptation du débit binaire, les bits sont transmis à un récepteur lequel, en cas d'une réception erronée d'un paquet de données comprenant les bits correspondants, demande une nouvelle transmission du paquet de données respectif, l'importance (w) des bits (x) du flux binaire, lequel est soumis à l'adaptation du débit binaire, étant sélectionnée en fonction du fait de savoir pour la combientième fois le paquet de données, auquel les bits correspondants (x) appartiennent, est transmis.

**9.** Procédé selon l'une quelconque des revendications précédentes,
**caractérisé en ce**
**que**, après l'adaptation du débit binaire, un entrelacement (4) des bits (y) prévus effectivement pour la transmission après l'adaptation du débit binaire est exécuté, une opération d'entrelacement séparée étant réalisée pour chaque groupe de bits dans lequel des bits (y) prévus pour la transmission avec respectivement une fiabilité identique (v) sont regroupés, de sorte que pour la réalisation de l'adaptation du débit binaire, pour chaque bit (y) prévu pour la transmission, la fiabilité correspondante peut être dérivée du fait de savoir à quelle opération d'entrelacement le bit (y) correspondant est amené.

**10.** Procédé selon l'une quelconque des revendications 1 à 8,
**caractérisé en ce**
**que** les fiabilités (v) pour les bits (y) individuels effectivement prévus pour la transmission après la réalisation de l'adaptation du débit binaire sont dérivées de fiabilités connues, avec lesquelles les bits correspondants, lors d'une modulation (5), sont représentés sur des symboles de modulation (13) correspondants devant être transmis.

**11.** Procédé selon la revendication 10,
**caractérisé en ce**
**qu'**un entrelacement (4) est exécuté après l'adaptation du débit binaire (3) et avant la modulation (5), les fiabilités (v) des bits (y) sortis par l'adaptation du débit binaire (3) et effectivement prévus pour la transmission étant dérivées par désentrelacement (11) à partir des fiabilités connues de la modulation (5).

**12.** Procédé selon l'une quelconque des revendications 1 à 8,
**caractérisé en ce**
**qu'**un entrelacement (4) est exécuté après l'adaptation du débit binaire (3), de telle manière qu'en raison de l'entrelacement l'ordre des bits (y) effectivement prévus pour la transmission reste inchangé au regard de leurs fiabilités (v), de sorte que pour la réalisation de l'adaptation du débit binaire, la fiabilité (v) pour les bits (y) prévus pour la transmission après l'adaptation du débit binaire peut être dérivée d'un index (n), avec lequel le bit (y) respectif est sorti par l'adaptation du débit binaire (3).

**13.** Procédé selon la revendication 12,
**caractérisé en ce**
**qu'**un dispositif d'entrelacement par bloc, avec des colonnes et des lignes, est utilisé pour l'entrelacement, le nombre des colonnes du dispositif d'entrelacement par bloc (4) étant premier par rapport au nombre des différentes fiabilités (v) des bits (y).

**14.** Procédé selon la revendication 13,
**caractérisé en ce**

**que** le nombre des lignes du dispositif d'entrelacement par bloc (4) est premier par rapport au nombre des différentes fiabilités (v).

15. Procédé selon l'une quelconque des revendications 1 à 8,
**caractérisé en ce**
**qu'**après l'adaptation du débit binaire (3), un entrelacement (4) est réalisé de telle manière qu'un nombre déterminé de bits (y) est toujours sorti avec la même fiabilité (v) par l'entrelacement pour être transmis, de sorte que, pour la réalisation de l'adaptation du débit binaire, la fiabilité (v) du bit (y) devant être effectivement transmis peut être dérivée d'un index (n), avec lequel le bit (y) respectif est sorti par l'adaptation du débit binaire.

16. Procédé selon la revendication 15,
**caractérisé en ce**
**que** l'entrelacement est réalisé au moyen d'un dispositif d'entrelacement par bloc (4) comprenant des lignes et des colonnes, le nombre de colonnes du dispositif d'entrelacement par bloc (4) étant divisible par le nombre des différentes fiabilités (v).

17. Dispositif de communication pour transmettre un flux binaire par l'intermédiaire d'un canal de transmission, comprenant un dispositif d'adaptation du débit binaire (3) pour l'adaptation du débit binaire du flux binaire devant être transmis, le dispositif d'adaptation du débit binaire (3) affectant les bits (x) du flux binaire devant être transmis pour l'adaptation du débit binaire, à des bits (y) effectivement utilisés pour la transmission de telle manière que pour un certain nombre (N) de bits successifs (x) du flux binaire devant être transmis, la somme d'importances (w), que les bits respectifs (x) du flux binaire présentent pour une récupération d'un message contenant le bit respectif, se trouvent dans un rapport prédéfini à la somme de fiabilités (v) des bits (y) correspondants effectivement utilisés pour la transmission, avec lesquelles ces bits peuvent transmettre un certain contenu informatif après la réalisation de l'adaptation du débit binaire,
l'adaptation du débit binaire étant réalisée par poinçonnage ou répétition des bits (x) du flux binaire, certains bits étant retirés lors de la poinçonnage resp. certains bits étant copiés lors de la répétition,
un taux de poinçonnage resp. de répétition, avec lequel les bits (x) du flux binaire sont poinçonnés resp. répétés pour l'adaptation du débit binaire, étant augmenté resp. baissé lorsqu'un quotient, obtenu à partir de la somme des importances (w) du certain nombre (N) de bits successifs (x) du flux binaire et de la somme des fiabilités (v) des bits correspondants effectivement utilisés pour la transmission, est supérieur à une valeur de seuil prédéfinie, et le débit de poinçonnage resp. de répétition, avec lequel les bits du flux binaire sont poinçonnés resp. répétés pour l'adaptation du flux binaire, étant baissé resp. augmenté lorsque le quotient est inférieur à la valeur de seuil prédéfinie.

18. Dispositif de communication selon la revendication 17,
**caractérisé en ce**
**que** le dispositif de communication (1) resp. le dispositif d'adaptation du débit binaire (3) est conçu pour la réalisation du procédé selon l'une quelconque des revendications 1 à 16.

19. Dispositif de communication selon la revendication 17 ou 18,
**caractérisé en ce**
**que** le dispositif de communication est un émetteur de radiocommunication mobile.

FIG 1

FIG 2

EP 1 423 935 B1

# FIG 3

# FIG 4

(100)    $e = e_{ini}$

(101)    $m = 1$
(102)    $n = 1$
(103)    do while $m <= N$
(104)         $e = e - e_{minus}(m)$
(105)         do while $e <= 0$
(106)              select bit for transmission
(107)              $e = e + e_{plus}(n)$
(108)              $n = n + 1$
         end do
(109)         $m = m + 1$
         end do

# FIG 5

**A)**

| | 1. | 2. | 3. | 4. | 5. |
|---|---|---|---|---|---|
| 1. | H | H | L | L | H |
| 2. | H | L | L | H | H |
| 3. | L | L | H | H | L |
| 4. | L | H | H | L | L |
| 5. | H | H | L | L | H |
| 6. | H | L | L | H | H |
| 7. | L | L | H | H | L |

**B)**

| | 1. | 2. | 3. | 4. | 5. |
|---|---|---|---|---|---|
| 1. | H | H | L | L | H |
| 2. | H | L | L | H | H |
| 3. | L | L | H | H | L |
| 4. | L | H | H | L | L |
| 5. | H | H | L | L | H |
| 6. | H | L | L | H | H |
| 7. | L | L | H | H | L |
| 8. | L | H | H | L | L |

**C)**

| | 1. | 2. | 3. | 4. | 5. | 6. | 7. | 8. |
|---|---|---|---|---|---|---|---|---|
| 1. | H | H | L | L | H | H | L | L |
| 2. | H | H | L | L | H | H | L | L |
| 3. | H | H | L | L | H | H | L | L |
| 4. | H | H | L | L | H | H | L | L |
| 5. | H | H | L | L | H | H | L | L |
| 6. | H | H | L | L | H | H | L | L |
| 7. | H | H | L | L | H | H | L | L |

# FIG 6

$i_1$

$i_2$ | Im | $i_1$ | 12

| $q_2$ | 1011 ⊘ | 1001 ⊘ | 0001 ⊘ | 0011 ⊘ 13 |
|---|---|---|---|---|
| | 1010 ⊘ | 1000 ⊘ | 0000 ⊘ | 0010 ⊘ |

Re

| $q_1$ | 1110 ⊘ | 1100 ⊘ | 0100 ⊘ | 0110 ⊘ |
|---|---|---|---|---|
| $q_2$ | 1111 ⊘ | 1101 ⊘ | 0101 ⊘ | 0111 ⊘ |

EP 1 423 935 B1